# EUROPEAN PATENT APPLICATION

(11) **EP 1 184 480 A2**
(43) Date of publication of application: **06.03.2002**
(21) Application number: 01118634.3
(22) Date of filing: 02.08.2001
(51) Int. Cl.: C23C 14/06, C23C 14/34, C23C 14/58, B30B 15/06, B24B 1/00

(54) **Polishing of press plates coated with titanium diboride**

(30) Priority: 01.09.2000 US 654075
(71) Applicant: Premark RWP Holdings, Inc., Wilmington, Delaware 19801 (US)
(72) Inventor: Odstrcil, Glenn L., Temple, Texas 76502 (US); Odstrcil, Kenneth W., Temple, Texas 76502 (US); Ayala, Richard L., Rogers, Texas 76569 (US); Bailey, Frederick L., Rosebud, Texas 76570 (US); Sanchez, Ruben M., Cameron, Texas 76520 (US)
(74) Representative: Howden, Christopher Andrew

(57) **Abstract**

The invention relates to a method for preparing a laminate press plate. The method is performed by first coating a planar pressing surface with diborides selected from the group consisting of hafnium diboride, molybdenum diboride, tantalum diboride, titanium diboride, tungsten diboride, vanadium diboride, or zirconium diboride or mixtures thereof. The coated planar pressing surface is then polished.

## Description

### BACKGROUND OF THE INVENTION

### 1. Field of the Invention

The invention relates to a method for treating laminate press plates. More particularly, the invention relates to a process for polishing titanium diboride coated laminate press plates.

### 2. Description of the Prior Art

In the manufacture of decorative laminate, layers of resin impregnated paper are pressed against press plates under controlled temperatures and pressures to cure the resin and bond the layers together. A high gloss press plate imparts a high gloss surface to the laminate. A textured surface plate imparts a textured surface to the laminate. The pressing surface of these plates are extremely uniform, with even microscopic discontinuities being minimized. The quality of a high gloss polished press plate can be determined by viewing reflected images on its surface and scrutinizing the reflected images for optical discrepancies.

Grit on the laminate surface causes micro-scratching of the stainless steel press plates normally used in the manufacture of decorative laminate. Specifically, melamine resin coated decorative laminates are pressed at temperatures of about 110-155°C and pressures of about 20-136 bar and preferably about 51-102 bar. Heating to these temperatures and cooling to room temperature results in substantial expansion and contraction of the press plate and laminate. Expansion and contraction of the laminate and press plate will not be the same, resulting in the movement of grit on the pressing surface of laminate across the press plate. Press plates may also be scratched by press plate handling equipment and by debris from pressing equipment or materials used in making laminate (Laurence U.S. Patent No. 5,244,275).

This scratching destroys the micro-finish of the press plate and adversely effects the resulting laminates produced thereby. It is, therefore, necessary to maintain the surface smoothness of the press plate to ensure the production of the highest quality laminate.

It is disclosed in National Manufacturers Association (NEMA) Standards Publication No. LD 3, that gloss finish laminate has a gloss of 70-100+. High gloss textured finish laminate is disclosed as having a gloss of 21-40. Black glass with a gloss of 94 ±1, measured at an angle of 60 degrees, is disclosed as the NEMA Standard 3.2.2 for calibrating a gloss meter for 60 degree angle gloss measurements.

Any scratching of high gloss press plates imparts visible surface defects to high gloss surfaces of laminate and reduce gloss level. Even discontinuities in high gloss press plates that can only be seen with a microscope can impart visible surface defects to a high gloss laminate surface.

While the removal of grit from the laminate surface might reduce the problem of press plate scratching, the grit on the decorative surface of laminate imparts abrasion resistance, a commercially desirable characteristic of laminate. Particles of alumina are commonly used as grit in making decorative laminate. The Vickers hardness of alumina is disclosed in "Tribology: Friction and wear of Engineering Materials", I.M. Hutchings, CRC Press, 1992, to be 1800 to 2000. A useful range of particle sizes is about 10 to about 75 microns. Grit of about 25-60 microns is preferred. Optimum abrasion resistance is obtained in the particle size range of about 40 to 60 microns. (Lane et. al. U.S. Patent 3,798,111)

Alumina having a maximum particle size of 9 microns is disclosed as being effective for imparting a wear resistant surface to glossy decorative laminate. Wear resistance is defined as the resistance of a glossy laminate to loss of gloss when the surface of laminate is exposed to the abrasive effects of sliding objects.

The use of a 410 stainless steel plate hardened by nitriding is disclosed for making high gloss decorative laminate. As disclosed, after pressing 100 sheets of high gloss laminate with 6 micron and 15 micron grit, the gloss of the pressed laminate remained good to very good.
The nitrided press plate exposed to the 6 micron grit was rebuffed after 234 cycles and produced acceptable laminate quality for at least another 103 cycles. Nitrided press plates exposed to 30 micron grit offered limited durability. It is disclosed that the 410 stainless steel press plate used for nitriding had a Rockwell, "C" scale hardness of 38-50 and that the nitrided surface had a Rockwell, "C" scale hardness of 60-70. The equivalent Vickers hardness of 410 stainless steel is about 370-440, based on a conversion table published in "Metals Handbook, Mechanical Testing", Vol. 8, 9^{th} ed., ASM, 1985. The equivalent Vickers hardness of nitrided 410 stainless steel is about 500-1000, based on a conversion table published in "Metals Handbook, Mechanical Testing," Vol. 8, 9^{th} ed., ASM, 1985. (Laurence U.S. Patent 5,244,375)

Laminate with 35 microns average particle size alumina at its surface (PGA 822 overlay, available commercially for Mead Corporation) has been pressed with high gloss press plates coated with titanium nitride. After ten pressings, the titanium nitride coated press plates had about 15 scratches per square centimeter. A control 410 stainless steel press plate had about 500 scratches per square centimeter. The Vickers hardness of titanium nitride is disclosed in "Tribology: Friction and wear of Engineering Materials", I.M. Hutchings, CRC Press, 1992, to be 1200 to 2000.

The control press plate and the press plate on which the titanium nitride was coated were cut from the same stainless steel pressing plate. The scratches were visible under a light microscope at 40X magnification. Titanium nitride was coated onto the 410 stainless steel high gloss press plates in a magnetron sputter coating system. The use of a magnetron sputter coating system for applying a titanium nitride coating is disclosed in "Multi-Cathode Unbalanced Magnetron Sputtering Systems," Sproul, Surface and Coating Technology, 49 (1991). The use of a magnetron sputter coating system for cleaning the surface that is to be coated is disclosed in "A New Sputter Cleaning System For Metallic Substrates," Schiller et. al., Thin Solid Films, 33 (1976).

Additionally, the color of the laminate pressed with the titanium nitride coated press plate was different than the color of the laminate pressed with the control press plate. An ASTM D 2244 color difference in comparison to a standard of less than ("0.5) ΔE is considered as an acceptable color match to the standard. The ASTM D 2244 color difference between a standard and laminate pressed with the titanium nitride coated press plate was greater than (0.5) ΔE. The titanium nitride coated press plates and laminate pressed therefrom had a bronze appearance. The control press plate and the laminate pressed therefrom did not have a bronze appearance. Laminate pressed with the control press plate had an ASTM D 2244 color difference when compared with the standard of less than (0.5) ΔE.

Iron-based cutting tools have been sputter coated with 2-6 microns of titanium diboride. The sputtering is carried out in an argon or krypton beam of ions accelerated to 1300-1800 volts as a broad-beam ion source. A titanium diboride target is arranged as a cathode. The tool is heated to about 200°C. Sputtering is done under a vacuum of about 4-6 milli-Torr. Titanium diboride has an extremely high Vickers micro-hardness value, typically about 3600, which is not only considerably higher than other borides but also substantially higher than other carbides or nitrides. Titanium diboride is also particularly noted for its high density, e.g., 88% of theoretical density, a low resistivity of 30 micro-ohms centimeters, a high strength of about 2,720 bar, and a coefficient of thermal expansion which is about 8.1 X 10⁻⁶ at the temperature range of 20-800°C. (Moskowitz et al., U.S. Patent Number 4,820,392)

Control conditions for sputter coating are disclosed in Influence of Apparatus Geometry and Deposition Conditions on the Structure and Topography of Thick Sputtered Coatings, Thornton, *Journal of Vacuum Science Technology*, Volume 11, Number 4, (July/August 1974) and Sputtering, Thornton et al., Metals Handbook, Ninth Edition, American Society of Metals, Metals Park, Ohio, 44073, Volume 5, pp 412-416, (1982).

There is a need for a hard coating on press plates, continuous belts, and other pressing surfaces that imparts a color to laminate having an ASTM D 2244 color difference in comparison to a standard of less than (".5) ΔE. There is a need for a coating that can be applied to a pressing surface without changing the appearance of the finish on the pressing surface. There is a need for a pressing surface that is not scratched when used in pressing laminate coated with alumina particles of greater than 10 microns and preferably greater than 25 microns. There is a particular need for a pressing surface that is not scratched when used in pressing high gloss laminate with an ASTM 2457 60 degree angle gloss of greater than 70, when the surface of the laminate is coated with 25-60 micron alumina particles. There is also a need for a method by which the pressing surface may be polished to optimize the gloss of laminate produced thereby.

### SUMMARY OF THE INVENTION

It is, therefore, an object of the present invention to provide a method for preparing a laminate press plate.

Accordingly, a first aspect of the present invention provides a method for preparing a laminate press plate, the method comprising the following steps: coating a planar pressing surface with diborides selected from the group consisting of hafnium diboride, molybdenum diboride, tantalum diboride, titanium diboride, tungsten diboride, vanadium diboride, or zirconium diboride or mixtures thereof; and polishing the coated planar pressing surface.

Preferably, the diboride is coated in a planar magnetron sputter coating system.

Advantageously, the coating step is performed by causing the planar pressing surface and a sputter head of the planar magnetron sputter coating system to move relative to one another at a scanning speed sufficient to provide a thermal gradient in the planar pressing surface at 10°C or less.

Conveniently, the diboride coating is applied to a Vickers hardness of at least 2000.

Preferably, the step of polishing is performed using at least one polishing pad comprising precisely shaped pyramids containing micron graded mineral.

Advantageously, the polishing pad is a 35-micron polishing pad.

Conveniently, the mineral is AlO₂.

Preferably, the at least one polishing pad is rotated at approximately 600 rpm.

Advantageously the plate is polished at a linear rate of approximately 7.62cm/minute.

According to another aspect of the present invention, there is provided a laminate press plate manufactured in accordance with the method defined above.

According to a still further aspect of the present invention, there is provided a method for manufacturing a decorative laminate, the method comprising the following steps: stacking a plurality of synthetic resin impregnated paper sheets; placing the resin impregnated paper sheets between laminate press plates to produce a laminate stack, wherein the laminate press plates are manufactured in accordance with the method defined above; and heating the laminate stack to temperatures for a time sufficient to consolidate the laminate and cure the resins.

The present invention also provides a decorative laminate manufactured in accordance with the above-defined method.

So that the invention may be more readily understood and so that further features thereof may be appreciated, embodiments will now be described by way of example, with reference to the accompanying drawings, in which:
Figure 1 is a flow chart outlining the present process.
Figure 2 is a perspective view of the buffer used in accordance with the present invention.
Figure 3 is a top plan view of the TRIZACT® polishing pads.

### DESCRIPTION OF THE PREFERRED EMBODIMENTS

The detailed embodiment of the present invention is disclosed herein. It should be understood, however, that the disclosed embodiment is merely exemplary of the invention, which may be embodied in various forms. Therefore, the details disclosed herein are not to be interpreted as limited, but merely as the basis for the claims and as a basis for teaching one skilled in the art how to make and/or use the invention.

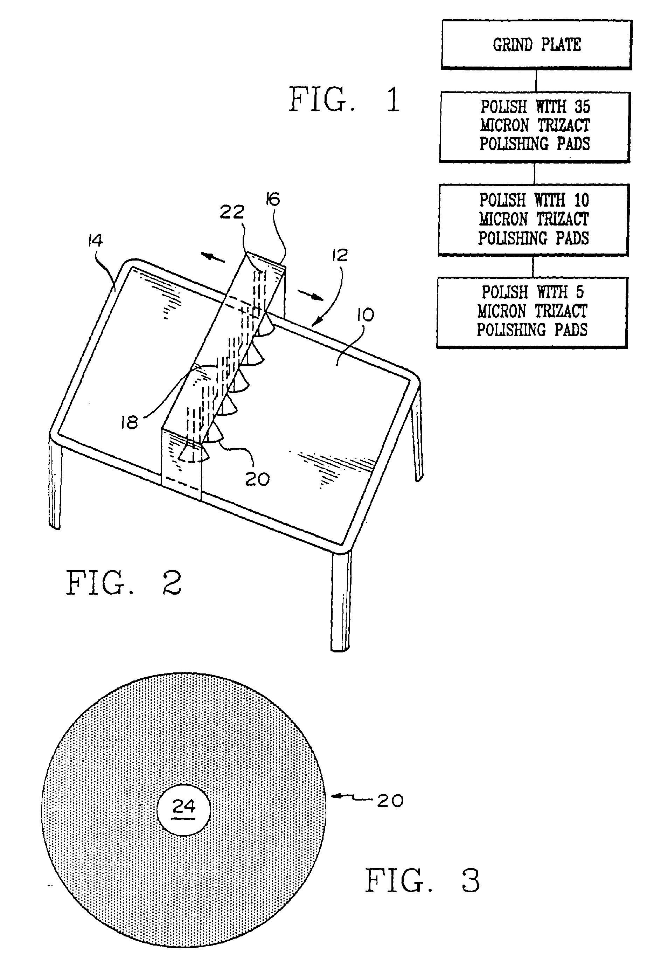

With reference to Figure 1, the present process for polishing diboride coated stainless steel press plates to produce a,laminate press plate is disclosed. Briefly, and in accordance with a preferred embodiment of the present invention, a stainless steel press plate is prepared by first coating a planar pressing surface of the press plate with diborides selected from the group consisting of hafnium diboride, molybdenum diboride, tantalum diboride, titanium diboride, tungsten diboride, vanadium diboride, zirconium diboride and mixtures thereof. The coated planar pressing surface is thereafter polished to remove any burrs and smooth the surface thereof.

The press plate is coated in the following manner. It has been discovered that the color, gloss and surface appearance of laminate made with pressing surfaces coated with diborides selected from the group consisting of hafnium diboride, molybdenum diboride, tantalum diboride, titanium diboride, tungsten diboride, vanadium diboride, zirconium diboride and mixtures thereof are substantially the same as the color and gloss of laminate made with the pressing surfaces before the coating is applied. The preferred diborides for coating laminate pressing surfaces are titanium diboride or zirconium diboride. The most preferred diboride for coating laminate pressing surfaces is titanium diboride. It is believed that titanium diboride is more commonly used commercially for coating surfaces than other members of the diborides of this invention because it can be sputter coated in a magnetron sputtering system at a higher deposition rate.

Grit, e.g., alumina particles, on the pressing surface of abrasion resistant decorative laminate can scratch press plates and reduce the visual quality of laminate thereafter made with the press plate. Press plates of this invention are particularly useful in making abrasion resistant high gloss decorative'laminate.

The stainless steel press plates are preferably 410 grade stainless steel, 304 grade stainless steel or Bohler 630 stainless steel, although a wide variety of plate materials may be used without departing from the spirit of the present invention. The raw steel from which the press plates are fabricated is initially prepared for subsequent polishing in accordance with the present invention. Initial preparation may include, but is not limited to, cutting, shaping, sizing, grinding and polishing stainless steel sheets purchased for use in accordance with the present invention. The initial polishing performed prior to the application of the coating is conventional directional polishing and may be performed in a variety of manners without departing from the spirit of the present invention.

In accordance with a preferred embodiment of the present invention, the plates are purchased in sizes appropriate for the fabrication of laminate press plates. The plates are commonly cut in a variety of sizes depending upon the specific application for which the plate is destined. For example, plates currently used come in 96.5 cm, 127 cm and 157.5 cm widths, 213.4 cm, 243.8 cm, 304.8 cm, and 365.56 cm lengths and 0.216 cm - 0.635 cm thicknesses. While specific dimensions are disclosed in accordance with the preferred embodiments of the present invention, the stainless steel press plate may take a variety of forms without departing from the spirit of the present invention.

As discussed above, grit, e.g, alumina particles, on the pressing surface of abrasion resistant decorative laminate can scratch press plates and reduce the visual quality of laminate thereafter made with the press plate. Press plates coated with diborides in accordance with the present invention are particularly useful in making abrasion resistant high gloss decorative laminate as the diboride coating protects the press plate's pressing surface from the abrasion of the grit found on the surface of the laminate.

The diboride coating of this invention can be applied on laminate press plate pressing surfaces to have a Vickers hardness of at least 2000 and preferably at least 2200, sufficient for pressing laminate with 25-60 micron or larger alumina particles at the pressing surface of the laminate without being scratched. A coating of about 3 microns has sufficient hardness to resist scratching by alumina particles on the pressing surface of laminate. The hardness of the coating can be controlled in a planar magnetron sputter coating system by those skilled in the use of these systems.

It has been discovered that the diboride coating of this invention can be coated on a pressing surface with sufficient bond strength for use in pressing high pressure laminate. A minimum bond strength of 1.6 and preferably 1.8 kilogram force (kgf) determined by diamond scratching bond testing is believed sufficient. Diboride coatings of greater than 6 microns can have lower bond strengths due to stresses produced during coating.

Bonding of the diboride coating of this invention to the press plate pressing surface is enhanced by thoroughly cleaning the press plate pressing surface before introducing the press plate pressing surface into a magnetron sputter coating system. Bonding is further enhanced by etching the press plate pressing surface with the magnetron sputter coating system prior to applying the titanium diboride coating. Cleaning, anodic etching, cathode etching and etching with radio frequency (RF) can be accomplished by methods known to those skilled in the use of a magnetron sputter coating system. It has been discovered that a layer of titanium applied directly onto the press plate pressing surface before applying the diboride coating of this invention further enhances the bonding of the diboride. Improving bonding by cleaning, etching and the use of an intermediate layer between the coating and substrate are known to those skilled in the art of using magnetron sputter coating systems.

The coating of press plates in accordance with the present invention can be performed either in a stationary mode or in a scanning mode. In the stationary mode, the magnetron sputtering is performed with both the sputtering head and the press plate stationary. However, sputtering in a stationary mode has been found to provide Vickers microhardness values (HV) of only up to about 1000.

A preferred method of coating the press plate of the present invention is to perform the coating process in a scanning mode, either by moving the press plate while keeping the sputtering head stationary or by moving the sputtering head while keeping the press plate stationary. The preferred mode for the scanning process is by moving the sputtering head. When the scanning process is used, the resulting coated press plate has been found by the present inventors to have much higher HV values (> 2000) at similar film thicknesses. In addition, when using the scanning process, the resulting film has increasing adhesion, on the order of 1.6 kgf or higher.

One drawback with the scanning process in a large production size vacuum coater for press plates of 121.9 cm x 243.8 cm dimensions, is that even though the film properties are similar to the small scale coaters at speeds of 5.08 cm/min, the press plate can undergo warping due to high thermal gradients (on the order of 38°C and higher) induced in the press plate during the process. It has been found that the thermal gradient induced in the plate can be reduced by an order of magnitude or more by increasing the scanning speed on a 121.9 cm x 243.8 cm plate to a speed of from 121.9 cm/min to 406.4 cm/min, preferably from 127 cm/min to 254/min, most preferably from 139.7 cm/min to 203.2 cm/min. Within the context of the present invention, the scanning speeds are given in linear cm per minute along the scanning direction, with a sputtering head that reaches completely across the short direction of the press plate, typically 121.9 cm in a production line. However, other methods of scanning are also possible with smaller sputtering heads. Such sputtering heads would be operated at similar linear speeds, but would require multiple passes to provide a single layer. In addition, the reduction in thermal gradient can be achieve while surprisingly maintaining the same film properties in the coated plate.

Modeling studies by the present inventors have shown that the thermal gradient can be reduced from 150°C at 20.3 cm/min down to -10°C at 406.4 cm/min. This reduction in thermal gradient has been experimentally confirmed by producing a coated press plate at scanning speeds of 200.7 cm/min and 88.9 cm/min, giving thermal gradients of -17.7°C (or negligible) and about -12.7°C, respectively.

This ability to reduce the thermal gradient and thus provide a more delocalized heat distribution throughout the plate is critical because built-in stress and a limited ceiling temperature for the press plate itself are practical limitations that must be considered in any production scale process. The thermal gradient in the present high scanning speed process is 10°C or less, preferably 1.7°C or less, more preferably -3.9°C or less, most preferably -9.4°C or less.

### EXAMPLES

Black, high gloss, high pressure laminate was pressed with titanium diboride coated press plates shown on Table 1. These press plates had been finished for imparting an ASTM D 2457 60 degree angle gloss of about 100 to laminate before being coated with titanium diboride. The ASTM D 2244 color difference between a standard and laminate pressed with the titanium diboride coated press plates shown on Table 1 was less than (0.5) ΔE. Gloss and color differences on Table 1, are averages of measurements made on 10 laminates.

**Table 1**

| Gloss and Color Differences | | |
|---|---|---|
| Press Plate | ASTM Gloss @ 60° | ASTM Color Difference, ΔE |
| 3000-1 | 101 | 0.20 |
| 3000-2 | 100 | 0.25 |
| 6000-1 | 101 | 0.35 |
| 6000-2 | 103 | 0.40 |
| 6000-3 | ' 102 | 0.30 |
| 6000-4 | 102 | 0.40 |
| 6000-5 | 103 | 0.45 |
| 6000-6 | 101 | 0.45 |

Additionally, high gloss Press Plate 3000-2 and a control press plate have been used in the pressing of 760 sheets of high pressure, black, high gloss laminate with 35 micron average particle size alumina particles on its pressing surface. Laminate was pressed with these press plates at about 68 bar and 138°C. The pressing surface of the laminate is commercially available overlay sheet with 35 micron alumina grit (PGA 822 from Mead). Press Plate 3000-2 and the control press plate were cut from a high gloss, 410 stainless steel press plate that had been finished for imparting an ASTM D 2457 60 degree angle gloss of about 100 to laminate. Press Plate 3000-2 and the control press plate measure about 30.48 cm along one side and 27.94 cm along their other side. Press Plate 3000-2 was coated with about five microns of titanium diboride in a magnetron sputter coating system. The titanium diboride coating was applied in 17 scans, applying about 3000 angstroms of titanium diboride per scan. The other was used as a control.

The first sheet of black, high gloss laminate with 35 micron average particle size alumina particles on its pressing surface pressed with the control press plate had an ASTM D 2244 color difference in comparison to a standard of about (0.25) ΔE. The first sheet of black, high gloss laminate pressed with Press Plate 3000-2 had an ASTM D 2244 color difference in comparison to a standard of about (0.15) ΔE.

The first sheet of black laminate pressed with the control press plate had an ASTM D 2457 60 degree angle gloss of about 100 to laminate. The 760^{th} sheet of black laminate pressed with the control press plate had an ASTM D 2457, 60 degree angle gloss of less than 70. The control press plate imparted a 60 degree angle gloss of less than 90 to black laminate after it had pressed about 160 sheets. It is believed that laminate with a 60 degree angle gloss of less than 90 is not commercially acceptable as a high gloss laminate.

These 760 sheets of black laminate pressed with Press Plate 3000-2 had an ASTM D 2457 60 degree angle gloss of about 100. Press Plate 3000-2 has been viewed under a microscope for scratches after pressing these 760 sheets of black laminate and none have been found. The control press plate is heavily scratched.

No differences were observed in the surface appearance of laminate pressed with the Press Plates shown on Table 1 and control press plates.

Titanium diboride was coated onto the high gloss press plate in a magnetron sputter coating system under a number of conditions. It is also believed that a coating of at least 3 microns is necessary for achieving a Vickers hardness of at least 2000 and that adhesion decreases at coating thicknesses of 6 microns or greater. Hardness and adhesion can be controlled, as known to those skilled in the art, by the pressure and temperature under which press plates are coated with the diborides of this invention and the power (amperes and volts) used in coating the diborides of this invention on press plates.

A textured press plate coated with titanium diboride, hereinafter "Press Plate 3000-3", and a control press plate have been used in the pressing of greater than 450 sheets of high pressure, black, textured laminate with 35 micron average particle size alumina particles on its pressing surface. This laminate was pressed at about 68 bar and 138°C. Press Plate 3000-3 and the control press plate were cut from a textured 630 stainless steel press plate that had been finished for imparting an ASTM D 2457 60 degree angle gloss of about 10 to laminate. Press Plate 3000-3 and the control press plate measure about twelve inches along each side. Press Plate 3000-3 was coated with about six microns of titanium diboride in a magnetron sputter coating system. The titanium diboride coating was applied in 20 scans, applying about 3000 angstroms of titanium diboride per scan.

The first sheet of this black, textured laminate pressed with the control press plate had an ASTM D 2244 color difference in comparison to a standard of about (0.22) ΔE. Black, high gloss laminate pressed with Press Plate 3000-3 had an ASTM D 2244 color difference in comparison to a standard of about (0.08) ΔE.

No differences were observed in the surface appearance of laminate pressed with the Press Plate 3000-3 and a control press plate.

The press plates on Table 1 and Press Plate 3000-3 were cleaned and then etched under radio frequency conditions in a planar magnetron sputter coating system. These press plates were then coated with titanium diboride in the magnetron sputter coating system under the following averaged conditions.

| Cleaning | |
|---|---|
| chemical cleaning | wipe with ethanol, trichloroethane and acetone |
| physical cleaning | 5 minute nitrogen gas blow over press plate |

| Radio Frequency Etching Conditions | |
|---|---|
| ' gas medium | argon |
| cm./minute scan speed | 2.54 |
| mTorr | 10 |
| MA/sq.cm. | .54 |
| kV | .75 |

| Titanium Diboride Coating Conditions | |
|---|---|
| Gas medium | argon |
| cm./minute scan speed | 2.54 |
| mTorr | 7 |
| MA/sq.cm. | 13 |
| kV | .3 |

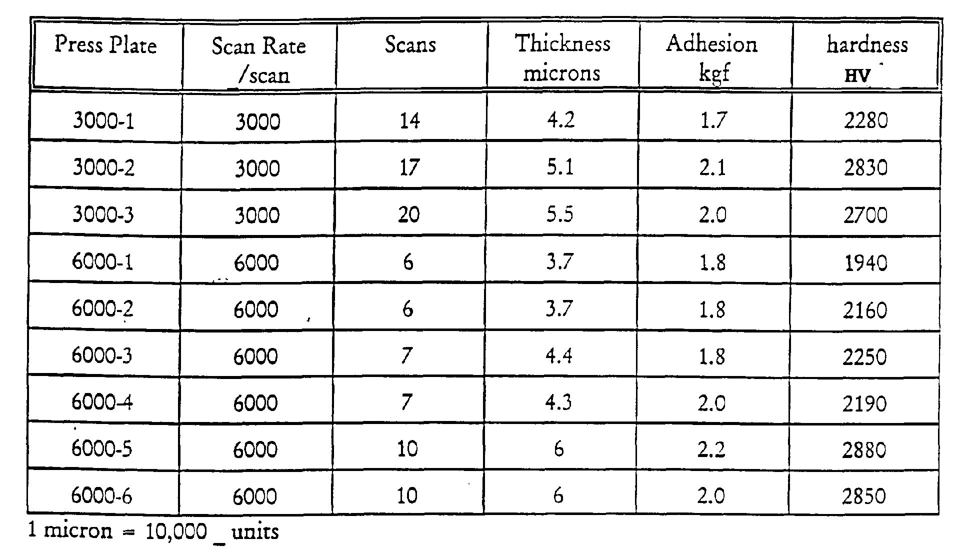

These high gloss press plates, measuring about four feet by eight feet, of this invention have been made. These press plates are referred to as Press Plates 3-1, 3-2 and 3-3. These press plates were sputter coated with titanium diboride under planar magnetron discharge conditions.

Press plates 3-1, 3-1 and 3-3 were anodically etched and then coated with titanium and titanium diboride in a planar magnetron sputter coating system under the following averaged conditions. These press plates were chemically cleaned before they were placed into the sputter coating system. The temperature of these press plates during etching and coating was about 149° C. These press plates did not warp at this temperature.

| Cleaning (Press Plates 3-1, 3-2 and 3-3) | |
|---|---|
| chemical cleaning | wipe with ethanol, trichloroethane and acetone |

| Anodic Etching (Press Plates | 3-1, | 3-2, | 3-3) |
|---|---|---|---|
| gas medium | argon | argon | argon |
| cm./minute scan speed | 7.6 | 7.6 | 7.6 |
| mTorr | 25 | 24 | 10 |
| mA/sq. cm | .72 | .45 | .45 |
| kV | .24 | .23 | .24 |
| number of scans | 1 | 1 | 5 |

| Titanium Coating Conditions (Press Plates | 3-1, | 3-2, | 3-3) |
|---|---|---|---|
| gas medium | argon | argon | argon |
| cm./minute scan speed | 7.6 | 7.6 | 7.6 |
| mTorr | 1.6 | 1.2 | 2.7 |
| mA/sq. cm | 11 | 11 | 11 |
| kV | .52 | .52 | .43 |
| number of Ti scans | 1 | 1 | 1 |

| Titanium Diboride Coating Conditions (Press Plates | 3-1, | 3-2, | 3-3) |
|---|---|---|---|
| gas medium | argon | argon | argon |
| cm./minute scan speed | 7.6 | 7.6 | 7.6 |
| mTorr | 1.6 | 1.2 | 2.7 |
| mA/sq. cm | 11 | 12 | 11 |
| kV | .52 | .60 | .50 |
| number of TiB₂ scans | 8 | 12 | 18 |
| deposition rate (_/scan) | 4125 | 5500 | 3000 |

| Properties of TiB₂/Ti Coating (Press Plates | 3-1, | 3-2, | 3-3) |
|---|---|---|---|
| thickness (microns) | 3.3 | 6.6 | 5.4 |
| adhesion (kgf) | * | 1.2* | ** |
| hardness (HV) | 2000 | 2500 | ** |

| | | | |
|---|---|---|---|
| * TiB2/Ti coating separated from Press Plats 3-1 and 3-2 during the pressing of laminate. | | | |
| ** The hardness and adhesion of Press Plate 3-3 has not been measured. Hardness and adhesion testing destroys the surface of a press plate. | | | |

Press plate 3-3 has been used in the pressing of greater than 1200 sheets of high pressure, black, high gloss laminate with 35 micron average particle size alumina particles on their pressing surfaces. Press Plates 3-3 was viewed for scratches after pressing these 1200 sheets of laminate and none have been found. The titanium diboride coating on Press Plates 3-1 and 3-2, separated from the stainless steel substrate after pressing less than 100 sheets of laminate.

A zirconium diboride coated high gloss press plate of this invention and a control press plate have each been used in the pressing of 10 sheets of black, high gloss laminate. This laminate had an ASTM D 2244 color difference in comparison to a standard of about (0.26) ΔE and an ASTM D 2457, 60 degree angle gloss of about 100. No differences were observed in the surface appearance of laminate pressed with the zirconium coated and control press plates.

A zirconium diboride coated high gloss press plate of this invention has been used in the pressing of 10 sheets of black, high gloss laminate with 35 micron average particle size alumina particles on its pressing surface. This laminate was pressed at about 68 bar and 138°C. A commercially available overlay sheet with 35 micron average particle size alumina grit (PGA 822 from Mead) is the pressing surface of the laminate. No scratches were observed on this press plate after the pressing of these 10 sheets of laminate.

The zirconium diboride press plate was cut from a high gloss, 410 stainless steel press plate having an ASTM D 2457, that had been finished for imparting a 60 degree angle gloss of about 100 to laminate. Two press plates measuring about 30.48 cm along each side were cut from this press plate. One was coated with about five microns of zirconium diboride in a planar magnetron sputter coating system. This press plate was etched under radio frequency conditions for about 15 minutes before the titanium diboride coating was applied. A 6 micron zirconium diboride coating was applied in 15 scans, applying about 4,000 angstroms of zirconium diboride per scan in a planar magnetron sputter coating system under the following averaged conditions.

| Cleaning | |
|---|---|
| chemical cleaning | wipe with ethanol, trichloroethane and acetone |
| physical cleaning | 5 minute nitrogen glass blow over press plate |

| Radio Frequency Etching Conditions | |
|---|---|
| gas medium | argon |
| cm./minute scan speed | 2.54 |
| mTorr | 10 |
| M.A/sq.cm. | .54 |
| kV | .75 |

| Zirconium Diboride Coating Conditions | |
|---|---|
| Gas medium | argon |
| cm./minute scan speed | 2.54 |
| mTorr | 7 |
| MA/sq.cm. | 9 |
| kV | .4 |

Black, laminate has been pressed with press plates, measuring six inches by six inches (15.24 cm X 15.24 cm), coated with titanium nitride in a magnetron sputter coating system.
The test results shown on Table 3 are the average results of pressing five sheets of laminate with each press plate.

**Table 4**

| Laminate Pressed With Titanium Nitride Coated Press Plates | | | | |
|---|---|---|---|---|
| | control #8 | TiN #8 | control #9 | TiN #9 |
| ASTM Gloss @ 60° | 100 | 95 | 100 | 95 |
| ASTM Color Difference, ΔE | 0.30 | 0.75 | 0.35 | 0.90 |

The gloss of the laminate pressed with the titanium nitride coated press plate was lower than the gloss of laminate pressed with the control press plate. The color of the laminate pressed with the titanium nitride coated press plate was significantly different from the color of the laminate pressed with the uncoated press plate. The titanium nitride coated press plates and laminate pressed with the titanium nitride press plates had a bronze appearance.

Black, laminate has been pressed with press plates, measuring 15.24 cm X 15.24 cm, coated with niobium nitride in a magnetron sputter coating system. The test results shown on Table 4 are the average results of pressing five sheets of laminate with each press plate.

**Table 5**

| Laminate Pressed with Niobium Nitride Coated Press Plates | | | |
|---|---|---|---|
| Black, High Gloss Laminate | control | B3 (3µm) | B5 (5µm) |
| ASTM Gloss @ 60° | 106 | 102 | 101 |
| ASTM Color Difference, ΔE | 0.09 | 0.65 | 0.85 |

The gloss of laminate pressed with niobium nitride coated press plates was lower than the gloss of laminate pressed with the press plate before it was coated. The color of laminate pressed with the niobium nitride coated press plates was significantly different from laminate pressed with press plates before they were coated.

Black, laminate has been pressed with press plates, measuring 15.24 cm X 15.24 cm, coated with diamond like coating in a magnetron sputter coating system. The laminate stuck to the diamond like coated press plate and was destroyed when it was separated.

Once the stainless steel press plate 10 is coated with a diboride in the manner discussed above, the plate is ready for polishing and is transferred to a wet buffer machine 12 (see Fig.2). In accordance with the preferred embodiment of the present invention, the wet buffer machine 12 is an IMEAS buffer. However, those skilled in the art will readily appreciate that various buffer machines may be used without departing from the spirit of the present invention.

Briefly, the buffer machine includes a support surface 14 upon which the coated stainless steel press plate 10 is positioned for treatment. The buffer machine 12 further includes a carriage 16 which moves a plurality (for example, 6-14) of rotary support members 18 above the surface being treated. The rotary support members 18 are designed for selective coupling to polishing pads 20 (see Fig. 3) which ultimately treat the surface of the coated stainless steel press plate 10. In accordance with a preferred embodiment of the present invention, each rotary support member 18 includes a coupling surface which is approximately 20.32 cm in diameter and is designed to support an 20.32 cm diameter polishing pad.

While specific dimensions are disclosed in accordance with a preferred embodiment of the present invention, pads and supports of other sizes may be used without departing from the spirit of the present invention. The rotary support members 18 are further provided with fluid passageways 22 permitting the passage of fluid to the polishing surface as the stainless steel press plates 10 are treated in accordance with the present invention.

The polishing pads 20 are TRIZACT® polishing pads manufactured by 3M® Company. 3M® TRIZACT® polishing pads consist of precisely shaped pyramids containing a micron graded mineral. In accordance with the present invention, the mineral is AlO₂, although other materials may be used without departing from the spirit of the present invention. As the abrasive is used, the tops of the pyramids wear away, continually exposing fresh abrasive. This ensures a consistent cut rate through the long life of the TRIZACT® polishing pads.

In accordance with a preferred embodiment of the present invention, the polishing procedure is performed by treating the coated surface of the stainless steel press plates with 35 micron TRIZACT® polishing pads (i.e., green color coded polishing pads). The polishing pads are secured to the rotary support members and applied to the stainless steel press plate. While a specific grit polishing pad is disclosed for use in accordance with a preferred embodiment of the present invention, it is contemplated that other grit polishing pads may be used without departing from the spirit of the present invention.

In accordance with the preferred embodiment of the present invention, the backing of the polishing pads 20 permits a hook and loop type attachment to the rotary support member 18, wherein the water used in conjunction with the polishing does not adversely effect the attachment of the polishing pads 20 to the rotary support members 18. However, as those skilled in the art will readily appreciate, various techniques may be employed for securing the polishing pads 20 to the rotary support members 18 without departing from the spirit of the present invention.

The rotary support members 18, and ultimately the polishing pads 20, are rotated at a speed of approximately 1 rpm - 1,500 rpm, and preferably a speed of approximately 600 rpm, with a flow of water sufficient to maintain an adequate slurry on the plate being polished. It has been found that ideal results are achieved where the water slurry is initially composed of tap water and subsequently converted to de-ionized water as the polishing process continues. The initial use of tap water is economical and provides the tolerances required during the initial polishing, while the de-ionized water provides the high tolerances required as the polishing process continues to produce a final surface.

The linear travel speed of the carriage 16 may be set from between 5.08 cm/minute to 152.4 cm/minute depending upon the rotary speed of the polishing pads 20 and the material being treated. Where the polishing pads 20 are rotated at a speed of 600 rpm, it has been found that ideal results are achieved when the linear travel speed of the carriage 16 is set at 7.62 cm/minute. The speeds disclosed above are merely exemplary of a preferred embodiment and may be varied without departing from the spirit of the present invention. Although it is contemplated that various operating parameters are within the spirit of the present invention, it has been found that ideal results are produced when the polishing pads are rotated at 600 rpm, the carriage is moved is at 60.96 cm/minute and 6 passes are performed with 10 micron TRIZACT® polishing pads.

In accordance with the preferred embodiment of the present invention, the polishing pads 20 make 4 complete passes across the stainless steel press plate 10. Movement of the polishing carriage 16 is controlled by a conventional control mechanism which ensures accurate application of the polishing pads 20. The speeds disclosed above are merely exemplary of a preferred embodiment and may be varied without departing from the spirit of the present invention.

The treated surface of the diboride coated stainless steel press plate 10 should now exhibit a high gloss, nondirectional finish ideal for producing high gloss decorative laminates. The opposite side of the stainless steel press plate may now be treated in the same manner, if desired, to produce a stainless steel press plate exhibiting a highly desirable high gloss finish on both its top and bottom surfaces.

Where a higher gloss is required additional polishing may be performed utilizing finer grit TRIZACT® polishing pads. For example, 10 micron and 5 micron TRIZACT® polishing pads may be used in a manner similar to that discussed above with regard to the polishing with 35 micron TRIZACT® polishing pads where a higher gloss producing plate is required.

By polishing the diboride coated press plate in the manner discussed above, the result press surface is scuff free and has been shown to increase the resulting gloss of the decorative laminates by as much as 70 points.

In addition to providing a nondirectional polished surface as discussed through out the application in substantial detail, the polishing as discussed below performs an important function with regard to the diboride coating. Specifically, the plate is coated with diboride in multiple passes. Each coating pass does not produce a uniform coating of the diboride and multiple passes produce a 100% coated plated. However, since each coating pass does not produce a uniform application, the final coating pass results in a slightly nonuniform surface. As such, the polishing steps discussed below brush off the uniform diborides to create an ideal surface.

While the preferred embodiments have been shown and described, it will be understood that there is no intent to limit the invention by such disclosure, but rather, is intended to cover all modifications and alternate constructions falling within the spirit and scope of the invention as defined in the appended claims.

In the present specification "comprise" means "includes or consists of" and "comprising" means "including or consisting of'.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. A method for preparing a laminate press plate, the method comprising the following steps:
coating a planar pressing surface with diborides selected from the group consisting of hafnium diboride, molybdenum diboride, tantalum diboride, titanium diboride, tungsten diboride, vanadium diboride, or zirconium diboride or mixtures thereof; and
polishing the coated planar pressing surface.

2. A method according to claim 1, wherein the diboride is coated in a planar magnetron sputter coating system.

3. A method according to claim 2, wherein the coating step is performed by causing the planar pressing surface and a sputter head of the planar magnetron sputter coating system to move relative to one another at a scanning speed sufficient to provide a thermal gradient in the planar pressing surface at 10°C or less.

4. A method according to any preceding claim, wherein the diboride coating is applied to a Vickers hardness of at least 2000.

5. A method according to any preceding claim, wherein the step of polishing is performed using at least one polishing pad comprising precisely shaped pyramids containing micron graded mineral.

6. A method according to claim 5, wherein the polishing pad is a 35-micron polishing pad.

7. A method according to claim 5 or claim 6, wherein the mineral is AlO₂.

8. A method according to claim 5, claim 6 or claim 7, wherein the at least one polishing pad is rotated at approximately 600 rpm.

9. A method according to any one of claims 5 to 8, wherein the plate is polished at a linear rate of approximately 7.62 cm/minute.

10. A laminate press plate manufactured in accordance with the method of any preceding claim.

11. A method for manufacturing a decorative laminate, the method comprising the following steps:
stacking a plurality of synthetic resin impregnated paper sheets;
placing the resin impregnated paper sheets between laminate press plates to produce a laminate stack, wherein the laminate press plates are manufactured in accordance with the method of any one of claims 1 to 9; and
heating the laminate stack to temperatures for a time sufficient to consolidate the laminate and cure the resins.

12. A decorative laminate manufactured in accordance with the method of claim 11.
